# EUROPEAN PATENT APPLICATION

(11) **EP 4 822 055 A1**
(43) Date of publication of application: **14.10.2026**
(21) Application number: 26162496.9
(22) Date of filing: 05.03.2026
(51) Int. Cl.: C23C 14/04, C23C 14/24, H10K 71/16

(54) **MASK ASSEMBLY AND DEPOSITION APPARATUS INCLUDING THE SAME**

(30) Priority: 11.04.2025 KR 20250047342
(71) Applicant: Samsung Display Co., Ltd., Yongin-si, Gyeonggi-do 17113 (KR)
(72) Inventor: Hong, Jaemin, 17113 Yongin-si,Gyeonggi-do (KR); Han, Jeehoon, 17113 Yongin-si, Gyeonggi-do (KR); Youngjin, Chon, 17113 Yongin-si, Gyeonggi-do (KR); Jang, Dae-Sik, 17113 Yongin-si, Gyeonggi-do (KR); Park, Joomook, 17113 Yongin-si, Gyeonggi-do (KR); Kim, Dong-Ki, 17113 Yongin-si, Gyeonggi-do (KR)
(74) Representative: Gulde & Partner

(57) **Abstract**

A mask assembly (10) includes a mask frame (100), a shielding stick (200, 200a), mask sticks (300), a first gap stick (110, 110a), and a thermal expansion control stick (400, 400a, 400b, 400c). The mask frame (100) is provided with an opening (100a). The shielding stick (200, 200a) extends across the opening (100a) in a first direction (DR1), with both opposing ends thereof coupled to the mask frame (100). Each of the mask sticks (300) extends across the opening (100a) in a second direction (DR2) intersecting the first direction (DR1), with both opposing ends thereof coupled to the mask frame (100). The first gap stick (110, 110a) may extend across the opening (100a) in the second direction (DR2), with both opposing ends thereof coupled to the mask frame (100) and overlapping, in a plan view, a first gap (G1) defined between the mask sticks (300). The thermal expansion control stick (400, 400a, 400b, 400c) extends across the opening (100a) in the second direction (DR2) and has a coefficient of thermal expansion less than a coefficient of thermal expansion of the first gap stick (110, 110a).

## Description

### BACKGROUND

### 1. Field

The present disclosure relates to a mask assembly, and more particularly, to a mask assembly having improved thermal expansion variation during a deposition process, and a deposition apparatus including the mask assembly.

### 2. Description of the Related Art

Electronic devices such as smartphones, digital cameras, laptop computers, navigation systems, and smart televisions that provide images to users include display devices for presenting the images. Such display devices may generate images and present the generated images to users via a display panel.

Various types of display panels, including liquid crystal display panels and organic light emitting display panels, have been developed for use in such display devices. Among the various types of display panels, the organic light emitting display panel includes light-emitting diodes that are self-luminous.

Each light-emitting diode typically includes an anode, a cathode, and a light-emitting layer. The light-emitting layer contains an organic material. A vacuum thermal deposition method may be used to form the light-emitting layer on the display panel.

**In** the vacuum thermal deposition method, a substrate is placed within a vacuum chamber, a mask is aligned with the substrate, and then a crucible of a deposition source is heated to evaporate deposition material, which is then deposited onto the substrate.

A fine metal mask (FMM) is commonly used as the deposition mask in such processes. The fine metal mask may be configured as an assembly structure including a mask frame, gap sticks, shielding sticks, and mask sticks.

### SUMMARY

Embodiments of the present disclosure provide a mask assembly having improved thermal expansion variation during a deposition process and a deposition apparatus including such a mask assembly.

According to an embodiment of the present disclosure, a mask assembly includes a mask frame, a shielding stick, mask sticks, a first gap stick, and a thermal expansion control stick. In such an embodiment, the mask frame is provided with an opening. In such an embodiment, the shielding stick extends across the opening in a first direction with both opposing ends thereof coupled to the mask frame. In such an embodiment, each of the mask sticks extends across the opening in a second direction intersecting the first direction with both opposing ends thereof coupled to the mask frame, and pattern holes is defined in each of the mask sticks. In such an embodiment, the first gap stick extends across the opening in the second direction with both opposing ends thereof coupled to the mask frame and overlaps, in a plan view, a first gap defined between the mask sticks. In such an embodiment, the thermal expansion control stick extends across the opening in the second direction with both opposing ends thereof coupled to the mask frame and overlaps, in the plan view, the first gap. In such an embodiment, the thermal expansion control stick has a coefficient of thermal expansion less than a coefficient of thermal expansion of the first gap stick.

According to an embodiment of the present disclosure, the first gap stick may overlap, in the plan view, a pair of mask sticks adjacent to the first gap among the mask sticks. In such an embodiment, the thermal expansion control stick may not overlap, in the plan view, the pair of mask sticks. In such an embodiment, the first gap stick may have magnetism less than magnetism of the mask sticks, and the thermal expansion control stick may have magnetism greater than the magnetism of the first gap stick.

According to an embodiment of the present disclosure, the thermal expansion control stick may include a material substantially the same as a material of the mask sticks.

According to an embodiment of the present disclosure, the shielding stick may include a first surface and a second surface which is opposite to the first surface and may face the mask frame. In such an embodiment, the mask sticks and the thermal expansion control stick may be disposed on the first surface of the shielding stick. In such an embodiment, the first gap stick may be disposed on the second surface of the shielding stick.

According to an embodiment of the present disclosure, the first gap stick may include a first sub-gap stick and a second sub-gap stick. In such an embodiment, the first sub-gap stick may overlap, in the plan view, one of the mask sticks which may be adjacent to the first gap. In such an embodiment, the second sub-gap stick may overlap, in the plan view, another one of the mask sticks which may be adjacent to the first gap. In such an embodiment, a first sub-gap may be defined between the first sub-gap stick and the second sub-gap stick.

According to an embodiment of the present disclosure, the thermal expansion control stick may overlap, in the plan view, the first sub-gap stick and the second sub-gap stick.

According to an embodiment of the present disclosure, the thermal expansion control stick may cover, in the plan view, the first sub-gap.

According to an embodiment of the present disclosure, the thermal expansion control stick may have a thickness, in a third direction intersecting the first direction and the second direction, greater than a thickness of the mask sticks.

According to an embodiment of the present disclosure, a second sub-gap may be defined between one of the mask sticks adjacent to the first gap and the thermal expansion control stick, and a third sub-gap may be defined between another one of the mask sticks adjacent to the first gap and the thermal expansion control stick.

According to an embodiment of the present disclosure, the second sub-gap and the third sub-gap may have substantially a same width as each other in the first direction.

According to an embodiment of the present disclosure, the second sub-gap and the third sub-gap may have different widths from each other in the first direction.

According to an embodiment of the present disclosure, the second sub-gap and the third sub-gap may not overlap, in the plan view, a first sub-gap defined in the first gap stick.

According to an embodiment of the present disclosure, the first surface of the shielding stick may be provided with an insertion groove into which at least a portion of the thermal expansion control stick may be inserted.

According to an embodiment of the present disclosure, the thermal expansion control stick may have a thickness, in the third direction intersecting the first direction and the second direction, less than a thickness of the mask sticks.

According to an embodiment of the present disclosure, the shielding stick may include a first surface and a second surface which is opposite to the first surface and may face the mask frame. In such an embodiment, the first gap stick and the thermal expansion control stick may be disposed on the second surface of the shielding stick, and the mask sticks may be disposed on the first surface of the shielding stick.

According to an embodiment of the present disclosure, the mask assembly may further include a second gap stick. In such an embodiment, the second gap stick may extend across the opening in the second direction with both opposing ends thereof coupled to the mask frame and may cover, in the plan view, a second gap defined between the mask sticks. In such an embodiment, the first gap may have a width in the first direction greater than a width of the second gap.

According to an embodiment of the present disclosure, the mask assembly may further include a second gap stick. In such an embodiment, the second gap stick may extend across the opening in the second direction with both opposing ends thereof coupled to the mask frame and may cover, in the plan view, a second gap defined between the mask sticks. In such an embodiment, the first gap may have a width in the first direction less than a width of the second gap.

According to an embodiment of the present disclosure, the thermal expansion control stick may include sub-thermal expansion control sticks arranged in parallel in the first direction. In such an embodiment, each of the sub-thermal expansion control sticks may extend across the opening in the second direction with both opposing ends thereof coupled to the mask frame.

According to another embodiment of the present disclosure, a mask assembly includes a mask frame, a shielding stick, mask sticks, a first gap stick, a second gap stick, and a thermal expansion control stick. In such an embodiment, the mask frame is provided with an opening. In such an embodiment, the shielding stick extends across the opening in a first direction with both opposing ends thereof coupled to the mask frame. In such an embodiment, each of the mask sticks extends across the opening in a second direction intersecting the first direction with both opposing ends thereof coupled to the mask frame, and pattern holes are provided in each of the mask sticks. In such an embodiment, the first gap stick extends across the opening in the second direction with both opposing ends thereof coupled to the mask frame and overlaps, in a plan view, a first gap defined between the mask sticks. In such an embodiment, the second gap stick extends across the opening in the second direction with both opposing ends thereof coupled to the mask frame and overlaps, in the plan view, a second gap defined between the mask sticks. In such an embodiment, the thermal expansion control stick extends across the opening in the second direction with both opposing ends thereof coupled to the mask frame and overlaps, in the plan view, the first gap. In such an embodiment, the first gap stick and the thermal expansion control stick has coefficients of thermal expansion which are different from each other.

In such an embodiment, the shielding stick may include a first surface and a second surface which is opposite to the first surface and may face the mask frame. In such an embodiment, the mask sticks and the thermal expansion control stick may be disposed on the first surface of the shielding stick. In such an embodiment, the first gap stick and the second gap stick may be disposed on the second surface of the shielding stick. In such an embodiment, the first gap may have a width in the first direction greater than a width of the second gap.

According to yet another embodiment of the present disclosure, a deposition apparatus includes a mask assembly, a deposition source, and a magnet plate. In such an embodiment, the deposition source emits a deposition material toward a substrate through the mask assembly. In such an embodiment, the magnet plate is disposed on a side of the mask assembly opposite to the deposition source and pulls the mask assembly toward the substrate by a magnetic force. In such an embodiment, the mask assembly includes a mask frame, a shielding stick, mask sticks, a first gap stick, and a thermal expansion control stick. In such an embodiment, the mask frame is provided with an opening. In such an embodiment, the shielding stick extends across the opening in a first direction with both opposing ends thereof coupled to the mask frame. In such an embodiment, the mask sticks each extends across the opening in a second direction intersecting the first direction with both opposing ends thereof coupled to the mask frame, and pattern holes are provided in each of the mask sticks. In such an embodiment, the first gap stick extends across the opening in the second direction with both opposing ends thereof coupled to the mask frame and overlaps, in a plan view, a first gap defined between the mask sticks. In such an embodiment, the thermal expansion control stick extends across the opening in the second direction with both opposing ends thereof coupled to the mask frame and overlaps, in the plan view, the first gap. In such an embodiment, the thermal expansion control stick has a coefficient of thermal expansion less than a coefficient of thermal expansion of the first gap stick.

According to embodiments of the present disclosure, it is possible to address the problem in which thermal expansion occurs more significantly in a central portion of the mask assembly than in an edge portion due to deposition heat and thus thermal expansion variation increases.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

These and/or other features will become apparent and more readily appreciated from the following description of the embodiments, taken in conjunction with the accompanying drawings in which:
FIG. 1 is a view showing a mask assembly according to an embodiment of the present disclosure;
FIGS. 2 to 6 are views showing an assembly sequence of the mask assembly of FIG. 1;
FIG. 7 is a cross-sectional view taken along line I-I' of FIG. 1;
FIG. 8 is a cross-sectional view taken along line II-II' of FIG. 1;
FIGS. 9 to 13 are views showing various embodiments with modifications of the structure illustrated in FIG. 7;
FIG. 14 is a view showing an embodiment with a modification of the structure illustrated in FIG. 8;
FIG. 15 is a view illustrating a deposition apparatus according to an embodiment of the present disclosure;
FIG. 16 is a view of a display panel manufactured using the deposition apparatus of an embodiment of the present disclosure;
FIG. 17 is a block diagram of an electronic device according to an embodiment of the present disclosure; and
FIG. 18 is a schematic view of electronic devices according to various embodiments of the present disclosure.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements throughout.

In the accompanying drawings, the thicknesses, ratios, and dimensions of the elements may not be to exact scale and may have been exaggerated for the benefit of effective explanation of the technical features associated with these elements. As such, the present disclosure shall not be restricted to the thicknesses, ratios, dimensions, etc. illustrated in the drawings.

When an element is described to be "disposed on," "placed on," "arranged on," "connected to," or "coupled to" another element, it shall be construed as being disposed on, placed on, arranged on, connected to, or coupled to the other element directly but also as possibly having another element therebetween. On the other hand, if one element is described to be "directly disposed on," "directly placed on," "directly arranged on," "directly connected to," or "directly coupled to" another element, it shall be construed that there is no other element interposed therebetween.

Moreover, relative terms, such as "below," "under," "beneath," "lower," "bottom," "above," "over," "upper," "top," etc., may be used herein to describe one element's relationship to another element as illustrated in the accompanying figures. It shall be understood that relative terms are intended to encompass different orientations of the device in addition to the orientation depicted in the accompanying figures. For example, if the device in one of the figures is turned over, elements described as being on the "lower" side of the other elements would then be oriented on "upper" sides of the other elements. The exemplary term "lower" can therefore encompass an orientation of both "lower" and "upper," depending on the particular orientation of the figure. Similarly, if the device in one of the figures is turned over, elements described as "below" or "beneath" other elements would then be oriented "above" the other elements. The exemplary term "below" or "beneath" can therefore encompass an orientation of both above and below.

Furthermore, when one device or layer is described to be "on," "over," "above," and the like, another device or layer, it shall also encompass the case of yet another device or layer disposed on, over, above, and the like, the other device or layer or interposed between the one device or layer and the other device or layer. On the contrary, when one device or layer is described to be "directly on," "directly over," "directly above," and the like, another device or layer, it shall mean that no other device or layer is interposed between the one device or layer and the other device or layer.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims as defined by the appended claims.

In the present disclosure, first through third directions DR1-DR3 may be defined. The first direction DR1 may be parallel to one side of a mask frame 100. The second direction DR2 may intersect the first direction DR1 and be parallel to another side of the mask frame 100. The third direction DR3 may intersect the first direction DR1 and the second direction DR2 and may be perpendicular to one surface of the mask frame 100. In the present disclosure, the phrase "in a plan view" may refer to a plan view as seen in the third direction DR3.

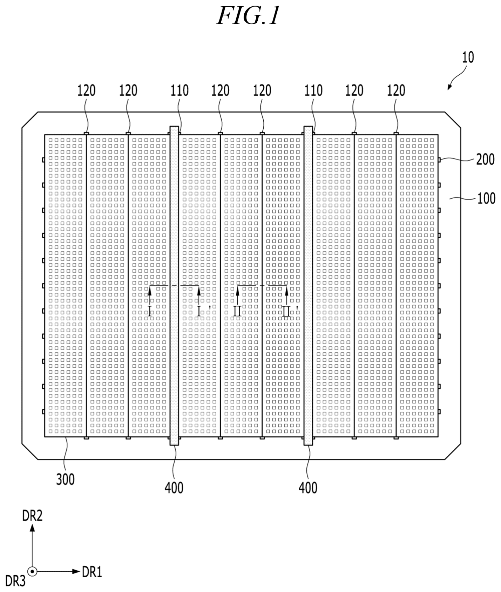

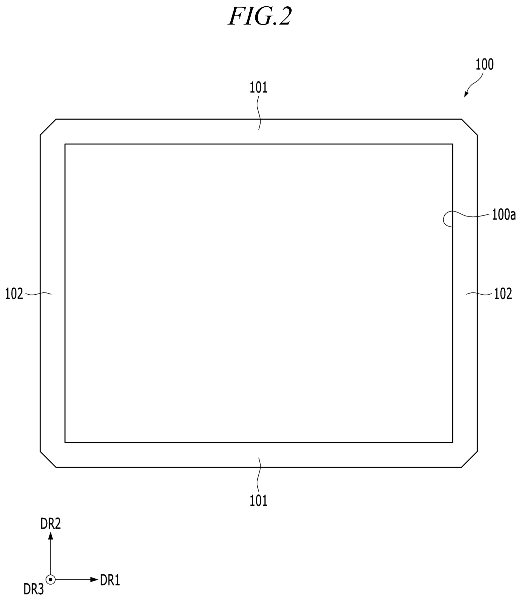

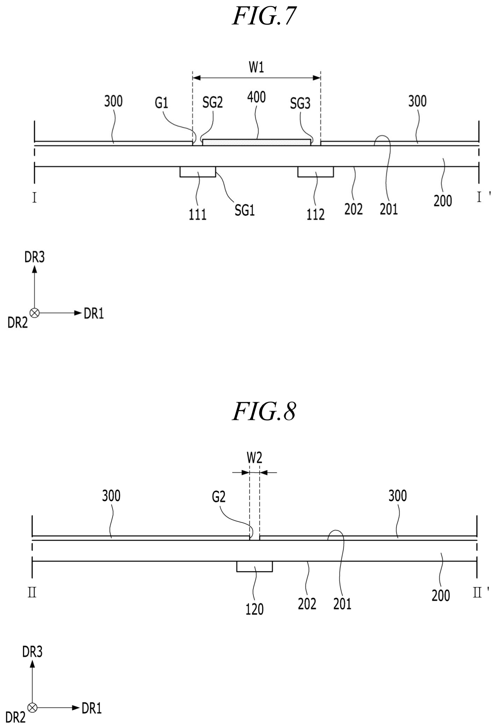

FIG. 1 is a view showing a mask assembly according to an embodiment of the present disclosure. FIGS. 2 to 6 are views showing an assembly sequence of the mask assembly of FIG. 1. FIG. 7 is a cross-sectional view taken along line I-I' of FIG. 1, and FIG. 8 is a cross-sectional view taken along line II-II' of FIG. 1.

Referring to FIG. 1, a mask assembly 10 according to an embodiment of the present disclosure may include a mask frame 100, first gap sticks 110, second gap sticks 120, shielding sticks 200, mask sticks 300, and thermal expansion control sticks 400. However, the mask assembly 10 is not limited to this configuration, and some of the above-described components may be omitted.

Referring to FIG. 2, in an embodiment, the mask frame 100 may be provided with an opening 100a, that is, the opening 100a may be defined through the mask frame 100. The mask frame 100 may have a rectangular frame shape such that a rectangular opening 100a is defined. However, the disclosure is not limited thereto, and the opening 100a may alternatively have a non-rectangular shape, such as a circular or hexagonal shape. For convenience of description, embodiments in which the mask frame 100 is provided with a rectangular opening 100a will hereinafter be mainly described.

The mask frame 100 may include a pair of first support portions 101 and a pair of second support portions 102. The pair of first support portions 101 may each extend in a first direction DR1 and may be arranged to face each other in a second direction DR2. Each of the pair of second support portions 102 may extend in the second direction DR2 to connect the pair of first support portions 101 and the pair of second support portions 102 may be arranged to face each other in the first direction DR1.

The pair of first support portions 101 and the pair of second support portions 102 may together define the opening 100a in a plan view (or when viewed in the third direction DR3). The length of each second support portion 102 in the second direction DR2 may be smaller than the length of each first support portion 101 in the first direction DR1. As a result, the opening 100a defined by the pair of first support portions 101 and the pair of second support portions 102 may have a rectangular shape in a plan view, with one side extending in the first direction DR1 being longer than another side extending in the second direction DR2.

In the present specification, the term "rectangular" is to be interpreted broadly to include not only a geometrically rectangular shape in a strict sense but also a rectangle-like shape in which corner portions are curved or chamfered.

In an embodiment, for example, the mask frame 100 may include or be made of a material having a small coefficient of thermal expansion. In some embodiments, the mask frame 100 may include or be made of INVAR 36 (iron-nickel alloy) or another iron-nickel alloy.

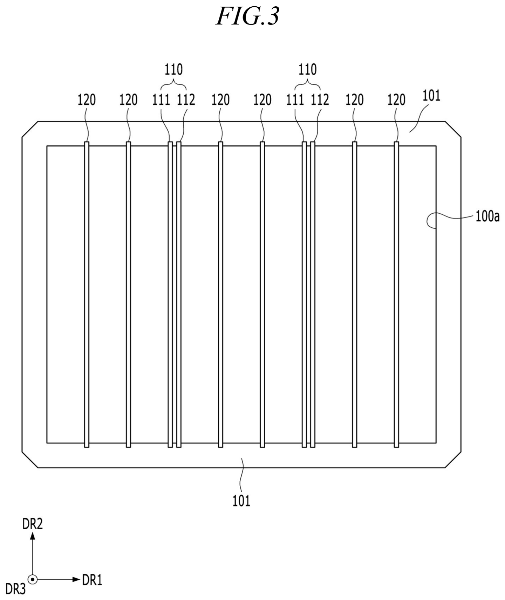

Referring to FIG. 3, each of the first gap sticks 110 may extend across the opening 100a in the second direction DR2 with both opposing ends thereof coupled to the first support portions 101 of the mask frame 100. Each of the first gap sticks 110 may include a first sub-gap stick 111 and a second sub-gap stick 112 spaced apart from each other in the first direction DR1. However, the disclosure is not limited thereto, and each of the first gap sticks 110 may alternatively be formed as an integral structure as shown in FIG. 1.

In some embodiments, both opposing ends of the first gap stick 110 in the second direction DR2 may be disposed on the pair of first support portions 101 in a state in which a tensile force is applied to the first gap stick 110 in the second direction DR2, and may be laser-welded to the pair of first support portions 101. In the present specification, an embodiment where the first gap stick 110 is coupled to the pair of first support portions 101 via laser-welding is described as an example, but this is merely illustrative, and other types of welding or fixing methods may be used instead.

A receiving groove may be provided (or defined) on one surface of the first support portion 101 to receive an end of the first gap stick 110.

Each of the second gap sticks 120, as illustrated in the drawings, may also extend across the opening 100a in the second direction DR2 with both opposing ends thereof coupled to the first support portions 101 of the mask frame 100.

In some embodiments, both opposing ends of the second gap stick 120 in the second direction DR2 may be disposed on the pair of first support portions 101 in a state in which a tensile force is applied to the second gap stick 120 in the second direction DR2, and may be laser-welded to the pair of first support portions 101.

A receiving groove may also be provided on one surface of the first support portion 101 to receive an end of the second gap stick 120.

The first gap sticks 110 and the second gap sticks 120 may serve to cover gaps formed between the mask sticks 300. The detailed arrangement of the first gap sticks 110 and the second gap sticks 120 will be described below with reference to other drawings.

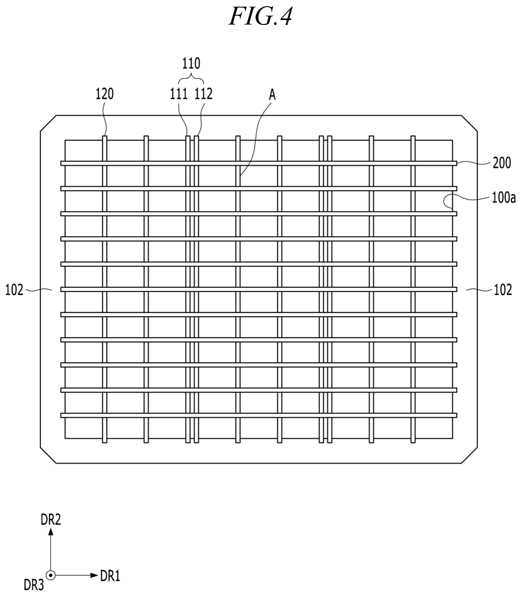

Referring to FIG. 4, each of the shielding sticks 200 may extend across the opening 100a in the first direction DR1 with both opposing ends thereof coupled to the second support portions 102 of the mask frame 100.

In some embodiments, both opposing ends of the shielding stick 200 in the first direction DR1 may be disposed on the pair of second support portions 102 in a state in which a tensile force is applied to the shielding stick 200 in the first direction DR1, and may be laser-welded to the pair of second support portions 102. In addition, the shielding stick 200 may be laser-welded to the first gap stick 110 and the second gap stick 120 in regions where the shielding stick 200 overlaps the first gap stick 110 and the second gap stick 120 in a plan view.

A receiving groove may be provided on one surface of the second support portion 102 to receive an end of the shielding stick 200.

The shielding stick 200 may serve to cover regions other than the deposition regions A. In an embodiment, for example, each of the mask sticks 300 may include pattern holes through which deposition material may pass, and some of the pattern holes may be obscured by the shielding stick 200. As a result, it is possible to effectively prevent the deposition material from being deposited on portions of the substrate other than the deposition regions A.

Each of the deposition regions A may refer to a portion of the opening 100a that is not covered, in a plan view, by the first gap stick 110, the second gap stick 120, or the shielding stick 200. The deposition regions A may correspond to cell regions of a substrate, which is the target for deposition. Here, each of the cell regions may constitute a single display panel through a cutting process of the substrate.

Although an embodiment where the deposition regions A is formed in a matrix shape of 12 rows and 9 columns is shown in FIG. 4, the disclosure is not limited thereto.

As illustrated, each of the deposition regions A may have a rectangular shape, in a plan view, in which one side extending in the first direction DR1 is longer than another side extending in the second direction DR2. As a result, the mask assembly 10 may be used in a deposition process for a substrate having a rotation structure in which each of the cell regions extends in the longitudinal direction of the substrate.

However, the disclosure is not limited thereto, and the deposition region A may alternatively have a rectangular shape in a plan view in which one side extending in the second direction DR2 is longer than another side extending in the first direction DR1. As a result, the mask assembly 10 may also be used in a deposition process for a substrate having a portrait structure in which each cell region extends in the short-side direction of the substrate.

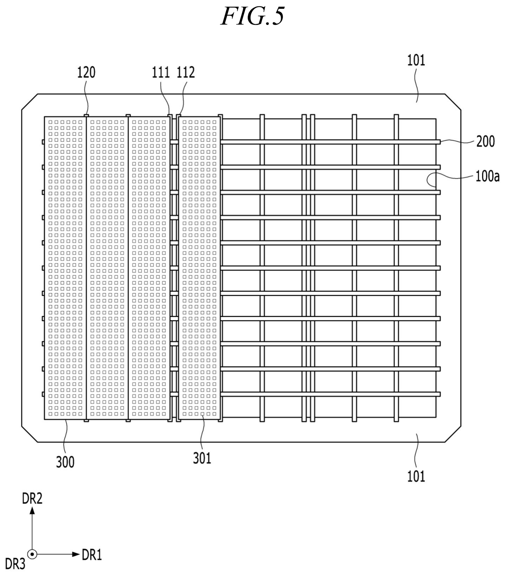

Referring to FIG. 5, each of the mask sticks 300 may extend across the opening 100a in the second direction DR2 with both opposing ends thereof coupled to the first support portions 101 of the mask frame 100.

In some embodiments, both opposing ends of the mask stick 300 in the second direction DR2 may be disposed on the pair of first support portions 101 in a state in which a tensile force is applied to the mask stick 300 in the second direction DR2, and may be laser-welded to the pair of first support portions 101. In such embodiments, the mask stick 300 may not be directly laser-welded or fixed to the first gap stick 110, the second gap stick 120, or the shielding stick 200, such that the mask stick 300 is not constrained by the first gap stick 110, the second gap stick 120, or the shielding stick 200.

A receiving groove may be provided on one surface of the first support portion 101 to receive an end of the mask stick 300.

Each of the mask sticks 300 may be provided with pattern holes 301 through which deposition material may pass. Each of the pattern holes 301 may be formed to penetrate (or may be defined through) the mask stick 300 in the third direction DR3.

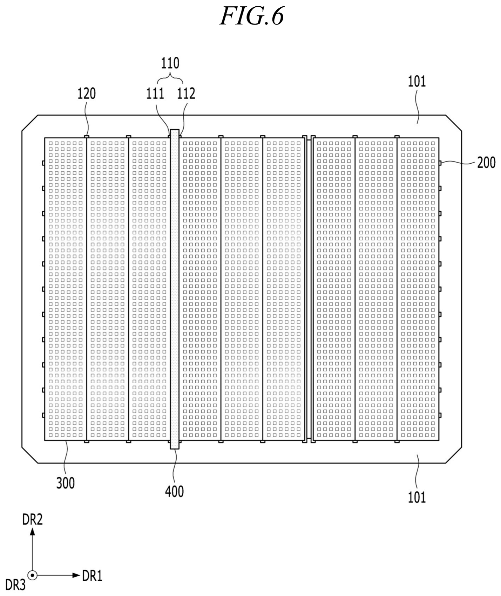

Referring to FIG. 6, each of the thermal expansion control sticks 400 may extend across the opening 100a in the second direction DR2 with both opposing ends thereof coupled to the first support portions 101 of the mask frame 100.

In some embodiments, both opposing ends of the thermal expansion control stick 400 in the second direction DR2 may be disposed on the pair of first support portions 101 in a state in which a tensile force is applied to the thermal expansion control stick 400 in the second direction DR2, and may be laser-welded to the pair of first support portions 101. Additionally, the thermal expansion control stick 400 may not be directly laser-welded or fixed to the first gap stick 110, the second gap stick 120, or the shielding stick 200, such that the thermal expansion control stick 400 is not constrained by the first gap stick 110, the second gap stick 120, or the shielding stick 200.

A receiving groove may be provided on one surface of the first support portion 101 to receive an end of the thermal expansion control stick 400.

Although FIGS. 2 to 6 sequentially illustrate assembly processes of the mask assembly 10, these are merely an example, and the mask assembly 10 may alternatively be assembled in a different order. In an embodiment, for example, the thermal expansion control sticks 400 may be assembled before the mask sticks 300.

Hereinafter, the specific arrangement relationships of the first gap stick 110, the second gap stick 120, the shielding stick 200, and the mask stick 300 will be described with reference to FIGS. 1 to 8.

Referring to FIGS. 7 and 8, gaps G1 and G2 may be provided (or defined) between the mask sticks 300. The gaps G1, G2 may include first gaps G1 and second gaps G2.

A first width W1 of each of the first gaps G1 in the first direction DR1 may be greater than a second width W2 of each of the second gaps G2 in the first direction DR1.

Each first gap G1, i.e., a wide gap, may be provided through a photolithography process performed prior to the deposition process. Specifically, a circuit layer of the display panel may be formed by the photolithography process. Since the photolithography process may not be performed over the entire substrate at once but rather sequentially over a plurality of photo regions obtained by dividing the substrate, it is desired to provide separation regions between the plurality of photo regions. Accordingly, the mask assembly 10 may also be desired to be provided with first gaps G1 corresponding to the separation regions of the substrate.

The second gaps G2 may be defined, in a plan view, between the first gaps G1 and the second support portions 102 of the mask frame 100.

The second gaps G2 may be arranged in an equal number between one second support portion 102 and an adjacent first gap G1, between another second support portion 102 and an adjacent first gap G1, and between the first gaps G1 themselves.

Referring to FIG. 7, the first gap stick 110 and the thermal expansion control stick 400 may overlap, in a plan view, the first gap G1. The thermal expansion control stick 400 may have a coefficient of thermal expansion less than that of the first gap stick 110. As a result, thermal expansion caused by deposition heat may be significantly or substantially reduced in a central portion of the mask assembly 10 where the thermal expansion control stick 400 is disposed.

The first gap stick 110 may be configured to cover the first gap G1, which is one of the gaps formed between the mask sticks 300, and may overlap, in a plan view, a pair of mask sticks 300 adjacent to the first gap G1. Accordingly, the first gap stick 110 may be desired to have magnetism less than that of the mask sticks 300.

Specifically, if the first gap stick 110 has magnetism greater than or substantially equal to magnetism of the mask sticks 300, there may be a problem in which, when the mask sticks 300 are brought into close contact with a substrate by magnetic force in a deposition apparatus, the first gap stick 110 presses on the mask sticks 300, causing deformation or breakage.

In the present specification, the term "magnetism" may refer to any of magnetic permeability, magnetic susceptibility, and magnetic moment.

The mask sticks 300 may include or be formed of a material having relatively high magnetism and a low coefficient of thermal expansion. In some embodiments, the mask sticks 300 may include or be made of INVAR 36 (iron-nickel alloy) or another iron-nickel alloy. The first gap stick 110 may include or be formed of a material having magnetism lower than a material of the mask sticks 300. In some embodiments, the first gap stick 110 may include or be made of stainless steel, e.g., SUS 420.

The thermal expansion control stick 400 may not overlap, in a plan view, the pair of mask sticks 300 adjacent to the first gap G1. Accordingly, the need for the thermal expansion control stick 400 to have lower magnetism than the mask stick 300 may be less critical than the need of the first gap stick 110 to have lower magnetism. The thermal expansion control stick 400 may have magnetism greater than that of the first gap stick 110. In some embodiments, the thermal expansion control stick 400 may include or be formed of a material having a lower coefficient of thermal expansion than the first gap stick 110, for example, INVAR 36 or another iron-nickel alloy.

The mask sticks 300 may be disposed on a first surface 201 of the shielding stick 200, and the first gap stick 110 may be disposed on a second surface 202 of the shielding stick 200. Here, the second surface 202 may be a surface on an opposite side of the first surface 201 and may face the mask frame 100. The first gap stick 110 may support the relatively long shielding stick 200 to improve sagging resistance.

The thermal expansion control stick 400 may be disposed on the first surface 201 of the shielding stick 200. As a result, even if the thermal expansion control stick 400 has high magnetism, the possibility of deformation or breakage of the mask sticks 300 due to the thermal expansion control stick 400 may be minimal.

Since the thermal expansion control stick 400 covers a substantial portion of the first gap G1, the first gap stick 110 may have a divided structure to cover only the remaining portions of the first gap G1. As a result, it is possible to reduce material costs and achieve benefits in terms of tensile force control.

In an embodiment, the first gap stick 110 may include a first sub-gap stick 111 and a second sub-gap stick 112. The first sub-gap stick 111 may overlap, in a plan view, one mask stick 300 adjacent to the first gap G1, and the second sub-gap stick 112 may overlap, in a plan view, another mask stick 300 adjacent to the first gap G1. A first sub-gap SG1 may be provided between the first sub-gap stick 111 and the second sub-gap stick 112.

The first sub-gap stick 111 and the second sub-gap stick 112 may each overlap, in a plan view, the thermal expansion control stick 400. The thermal expansion control stick 400 may cover, in a plan view, the first sub-gap SG1 provided between the first sub-gap stick 111 and the second sub-gap stick 112. Unlike the mask sticks 300, the thermal expansion control stick 400 may not be provided with pattern holes.

In an embodiment, the thermal expansion control stick 400 may have a thickness greater than that of the mask sticks 300 in the third direction DR3. As a result, the cost associated with manufacturing a thin sheet at a smaller thickness may be reduced. In such an embodiment, the thermal expansion control stick 400 may protrude more than the mask sticks 300, which could otherwise hinder the mask sticks 300 from closely adhering to the substrate. However, this problem may be mitigated by arranging the thermal expansion control stick 400 to be spaced apart from the pair of mask sticks 300 adjacent to the first gap G1.

In some embodiments, a second sub-gap SG2 may be provided between one mask stick 300 adjacent to the first gap G1 and the thermal expansion control stick 400, and a third sub-gap SG3 may be provided between another mask stick 300 adjacent to the first gap G1 and the thermal expansion control stick 400. The second sub-gap SG2 and the third sub-gap SG3 may have substantially the same width in the first direction DR1 as each other.

However, the disclosure is not limited thereto, and the width of the second sub-gap SG2 in the first direction DR1 may differ from the width of the third sub-gap SG3 in the first direction DR1. In an embodiment, for example, the thermal expansion control stick 400 may be shifted to the right from the position illustrated in FIG. 7. In such an embodiment, the width of the second sub-gap SG2 in the first direction DR1 may be greater than the width of the third sub-gap SG3 in the first direction DR1. In another embodiment, for example, the thermal expansion control stick 400 may be shifted to the left from the position illustrated in FIG. 7, in which case, the width of the second sub-gap SG2 in the first direction DR1 may be less than the width of the third sub-gap SG3 in the first direction DR1.

In an embodiment where the thermal expansion control sticks 400 are shifted as described above, the thermal expansion control stick 400 disposed on the left side of the mask assembly 10 relative to the center may be shifted in the opposite direction from the thermal expansion control stick 400 disposed on the right side. In an embodiment, for example, where the thermal expansion control stick 400 on the left side of the mask assembly 10 is shifted to the right, the thermal expansion control stick 400 on the right side of the mask assembly 10 may be shifted to the left.

In some embodiments, the thickness of the first gap stick 110 in the third direction DR3 may be in a range from about 45 micrometers (µm) to about 55 µm. The thickness of the shielding stick 200 in the third direction DR3 may be in a range from about 90 µm to about 110 µm. The thickness of the mask stick 300 in the third direction DR3 may be in a range from about 18 µm to about 22 µm. The thickness of the thermal expansion control stick 400 in the third direction DR3 may be in a range from about 27 µm to about 33 µm. However, the disclosure is not limited thereto, and the thickness of the thermal expansion control stick 400 in the third direction DR3 may be greater than about 33 µm, for example, about 50 µm, about 100 µm, or other values.

Referring to FIG. 8, the second gap stick 120 may cover the second gap G2 in a plan view.

The width of the second gap stick 120 in the first direction DR1 may be greater than a second width W2 of the second gap G2 in the first direction DR1. The second gap stick 120 may overlap, in a plan view, a pair of mask sticks 300 adjacent to the second gap G2.

The second gap stick 120 may be disposed on the second surface 202 of the shielding stick 200. The second gap stick 120 may support the relatively long shielding stick 200 to improve sagging resistance.

The second gap stick 120 may include or be formed of a material substantially the same as a material of the first gap stick 110. In some embodiments, the second gap stick 120 may include or be made of stainless steel, e.g., SUS 420.

In some embodiments, the thickness of the second gap stick 120 in the third direction DR3 may be in a range from about 45 µm to about 55 µm. In some embodiments, the width of the first sub-gap stick 111, the second sub-gap stick 112, or the second gap stick 120 in the first direction DR1 may each be in a range from about 2 mm to about 3 mm. The width of the thermal expansion control stick 400 in the first direction DR1 may be in a range from about 17 mm to about 21 mm. However, the disclosure is not limited thereto, and the width of the thermal expansion control stick 400 in the first direction DR1 may be greater or less, for example, about 10 mm, about 30 mm, or other values.

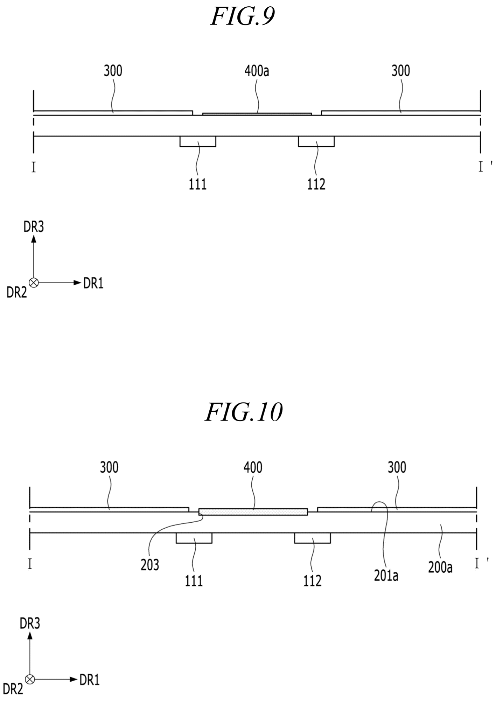

FIGS. 9 to 13 are views showing various embodiments with modifications of the structure illustrated in FIG. 7.

Referring to FIG. 9, in an embodiment, a thermal expansion control stick 400a may have a thickness in the third direction DR3 less than that of the mask sticks 300. In such an embodiment, the thickness of the thermal expansion control stick 400a in the third direction DR3 may be in a range from about 9 µm to about 11 µm. However, the disclosure is not limited thereto, and the thermal expansion control stick 400a may alternatively have a thickness in the third direction DR3 substantially equal to that of the mask sticks 300.

Referring to FIG. 10, in an embodiment, an insertion groove 203 may be provided on a first surface 201a of a shielding stick 200a, and at least a portion of the thermal expansion control stick 400 may be inserted into the insertion groove 203.

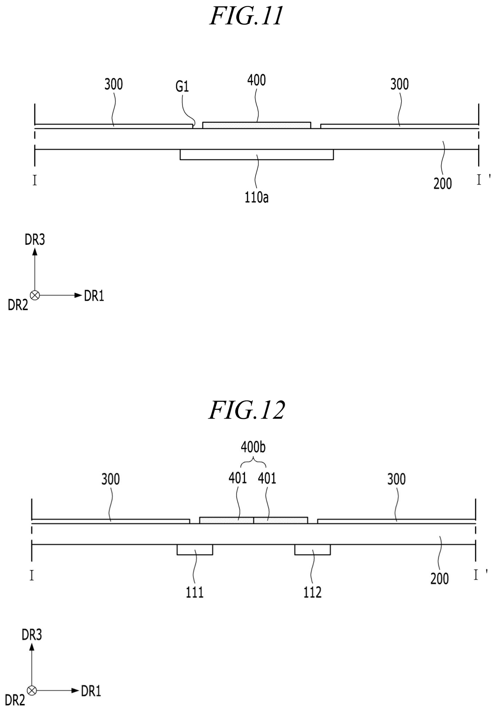

Referring to FIG. 11, in an embodiment, a first gap stick 110a may be formed as an integrated structure. In such an embodiment, the first gap stick 110a may cover the first gap G 1 in a plan view.

Referring to FIG. 12, in an embodiment, a thermal expansion control stick 400b may include sub-thermal expansion control sticks 401. Each of the sub-thermal expansion control sticks 401 may extend across the opening 100a in the second direction DR2 with both opposing ends thereof coupled to the first support portions 101 of the mask frame 100. The sub-thermal expansion control sticks 401 may be arranged in parallel in the first direction DR1.

In such an embodiment, the thermal expansion control stick 400b may be defined by two sub-thermal expansion control sticks 401. However, the disclosure is not limited thereto, and the thermal expansion control stick 400b may alternatively be defined by three or more sub-thermal expansion control sticks 401.

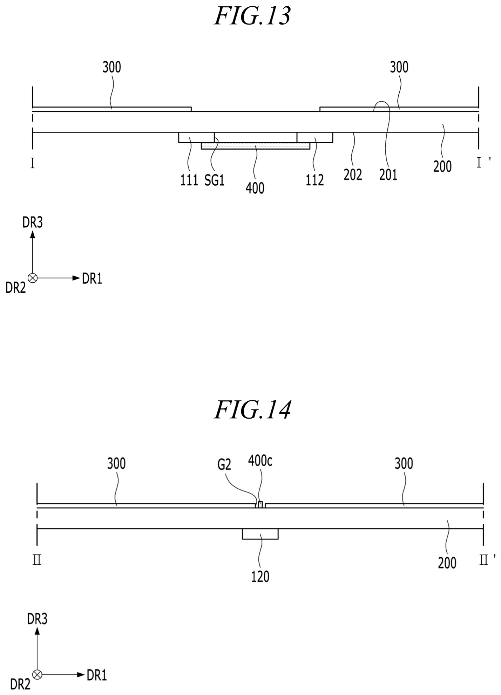

Referring to FIG. 13, in an embodiment, the thermal expansion control stick 400 may be disposed on a second surface 202 of the shielding stick 200, instead of the first surface 201. In such an embodiment, the thermal expansion control stick 400 may overlap, in a plan view, the first sub-gap stick 111 and the second sub-gap stick 112 and may cover the first sub-gap SG1.

However, the structure illustrated in FIG. 7 may improve the shadow issue in which the increased thickness of lower structures of the mask sticks 300 interferes with the movement of deposition material.

FIG. 14 is a view showing an embodiment with a modification of the structure illustrated in FIG. 8. Referring to FIG. 14, in an embodiment, a thermal expansion control stick 400c may be disposed to overlap, in a plan view, the second gap G2 rather than the first gap G1.

In such an embodiment, the thermal expansion control sticks 400, 400a, 400b that overlap the first gap G1 may be omitted, and the first gap stick 110a may be formed as an integrated structure. However, the structures illustrated in FIGS. 7 and 8 may effectively allow the thermal expansion control stick 400 to secure a sufficient cross-sectional area desired for thermal expansion control.

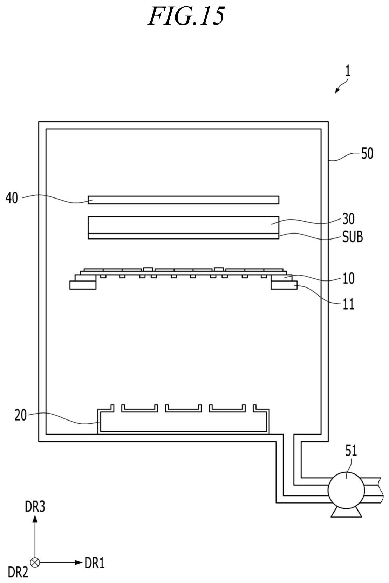

FIG. 15 is a view illustrating a deposition apparatus according to an embodiment of the present disclosure. In FIG. 15, the mask assembly 10 is schematically illustrated for convenience of illustration and description. Referring to FIG. 15, a deposition apparatus 1 according to an embodiment of the present disclosure may include a mask assembly 10, a mask support 11, a deposition source 20, an electrostatic chuck 30, a magnet plate 40, and a vacuum chamber 50. However, the disclosure is not limited thereto, and some of the above-described components of the deposition apparatus 1 may be omitted.

The mask assembly 10 may be positioned above the deposition source 20 within the vacuum chamber 50. The features of the mask assembly 10 described with reference to FIGS. 1 to 14 may be applied hereto, and thus any repetitive detailed description thereof will be omitted in this embodiment.

The mask support 11 may support the mask frame 100 of the mask assembly 10. The mask support 11 may be transported by a first transport device (not shown) to, for example, align the mask assembly 10. In the present specification, the term "transport device" may refer to one of the transport devices commonly used in deposition apparatuses within a display panel manufacturing line, but the disclosure is not limited thereto.

The deposition source 20 may be disposed within the vacuum chamber 50 and may be configured to emit deposition material toward the mask assembly 10. The deposition source 20 may include a crucible, a heater, and a nozzle. The crucible may have deposition material stored therein. The heater may be configured to heat the deposition material stored in the crucible. The nozzle may be configured to discharge the deposition material vaporized within the crucible.

The deposition material emitted from the deposition source 20 may pass through pattern holes of the mask assembly 10 and be deposited on a substrate SUB.

The electrostatic chuck 30 may be disposed within the vacuum chamber 50 on a side opposite to the deposition source 20 relative to the mask assembly 10. The substrate SUB may be attached to the electrostatic chuck 30 by electrostatic force.

**In** an embodiment, for example, the substrate SUB may be a mother substrate for fabricating a display panel as described later. The substrate SUB may be provided with a plurality of cell regions, each of which may form a single display panel through a process of cutting the substrate SUB.

Prior to attachment to the electrostatic chuck 30, the substrate SUB may be supported by a substrate support. The electrostatic chuck 30 may be transported by a second transport device (not shown) for transporting and aligning the substrate SUB.

The magnet plate 40 may be disposed within the vacuum chamber 50 on a side opposite to the deposition source 20 relative to the mask assembly 10, and on a side opposite to the mask assembly 10 relative to the electrostatic chuck 30. The magnet plate 40 may be configured to provide a magnetic force that pulls the mask assembly 10 toward the substrate SUB so that the mask assembly 10 can be brought into close contact with the substrate SUB.

The magnet plate 40 may be transported by a third transport device (not shown). In an embodiment, for example, after the substrate SUB is lowered and seated on the mask assembly 10 in a state of being attached to the electrostatic chuck 30, the magnet plate 40 may be lowered by the third transport device. As a result, the mask assembly 10 may be brought into close contact with the substrate SUB by the magnetic force provided by the magnet plate 40.

The vacuum chamber 50 may be configured to provide a sealed internal space in which the mask assembly 10, the deposition source 20, the electrostatic chuck 30, and the magnet plate 40 are arranged. A vacuum pump 51 may be connected to the vacuum chamber 50. The vacuum pump 51 may be configured to lower the pressure in the internal space of the vacuum chamber 50.

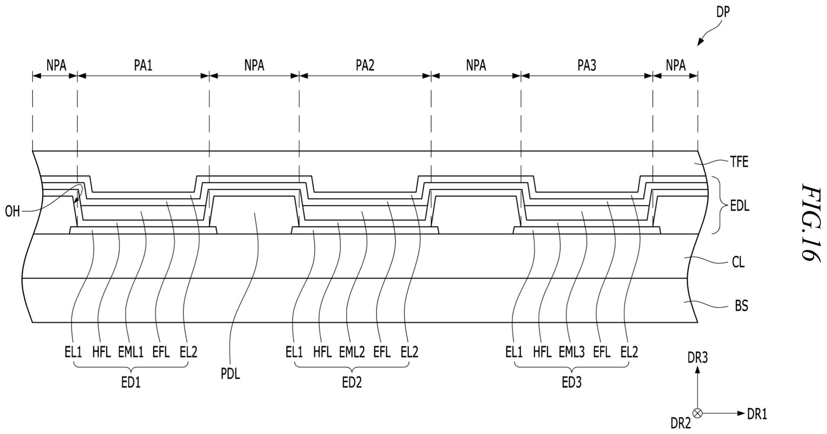

FIG. 16 is a view of a display panel manufactured using the deposition apparatus according to an embodiment of the present disclosure.

Hereinafter, the first to third directions DR1-DR3 may be defined as described above or alternatively defined as follows. The first direction DR1 may be parallel to one side of a display panel DP. The second direction DR2 may intersect the first direction DR1 and may be parallel to another side of the display panel DP. The third direction DR3 may be perpendicular to a surface of the display panel DP. In the following description, the expression "in a plan view" may refer to a view as seen in the third direction DR3.

Referring to FIG. 16, a display device according to an embodiment of the present disclosure may be an image display device and may include a display panel DP. The display panel DP may include a base substrate BS, a circuit layer CL, an emission device layer EDL, and an encapsulation layer TFE.

The base substrate BS may serve as a member providing a base surface on which the circuit layer CL is disposed. The base substrate BS may include glass, ceramic, metal, or a polymer resin such as polyimide. However, the disclosure is not limited thereto, and the base substrate BS may alternatively be an inorganic layer, an organic layer, or a composite material layer, and may be a single layer or a multilayer structure.

The circuit layer CL may be disposed on the base substrate BS and may include pixel circuits and signal lines. The pixel circuits may include pixel transistors for driving light-emitting diodes. Additionally, the circuit layer CL may include peripheral transistors disposed in a non-display area of the display panel DP for outputting signals to control the pixel transistors of the pixel circuits.

In an embodiment of the display panel DP, a display area and a non-display area may be defined. The display area is an area where images are displayed, and the non-display area is an area surrounding the display area where images are not displayed. Pixels for implementing images may be arranged in the display area. Each pixel may include a light-emitting diode and a pixel circuit, and the pixel circuit may be configured to control driving of the light-emitting diode.

The emission device layer EDL may be disposed on the circuit layer CL and may include light-emitting diodes ED1, ED2, ED3 and a pixel defining layer PDL.

Each of the light-emitting diodes ED1, ED2, ED3 may include a first electrode EL1, a hole functional layer HFL, an emission layer EML1, EML2, EML3, an electron functional layer EFL, and a second electrode EL2.

The pixel defining layer PDL may be disposed on the circuit layer CL and may be arranged to cover an area between the first electrodes EL1 in a plan view. The pixel defining layer PDL may correspond to a non-emission area NPA and may serve to separate the light-emitting diodes ED1, ED2, ED3. The pixel defining layer PDL may include at least one organic insulating materials selected from polyimide, polyamide, acrylic resin, benzocyclobutene, and phenolic resin.

The first electrode EL1 may be disposed on the circuit layer CL. The first electrode EL1 may be conductive and electrically connected to the pixel transistor to receive an electrical signal.

The hole functional layer HFL may be disposed between the first electrode EL1 and the emission layer EML1, EML2, EML3, while the electron functional layer EFL may be disposed between the second electrode EL2 and the emission layer EML1, EML2, EML3. However, the disclosure is not limited thereto, and the positions of the hole functional layer HFL and the electron functional layer EFL may be switched depending on the polarities of the first and second electrodes EL1, EL2.

The hole functional layer HFL and the electron functional layer EFL may be provided as common layers, as illustrated. However, the disclosure is not limited thereto, and either or both of the hole functional layer HFL and the electron functional layer EFL may be patterned and disposed only within openings OH defined in the pixel defining layer PDL.

The emission layers EML1, EML2, EML3 may be disposed within the openings OH defined in the pixel defining layer PDL. At least some of the emission layers EML1, EML2, EML3 may be configured to emit light in different wavelength ranges. In an embodiment, for example, the emission layer EML1 of the first light-emitting diode ED1 may be configured to emit red light, the emission layer EML2 of the second light-emitting diode ED2 may be configured to emit green light, and the emission layer EML3 of the third light-emitting diode ED3 may be configured to emit blue light. However, the disclosure is not limited thereto, and the emission layers EML1, EML2, EML3 of the first to third light-emitting diodes ED1, ED2, ED3 may be configured to emit light of the same wavelength range, for example, blue light.

The emission layers EML1, EML2, EML3 may be formed by the deposition apparatus 1 according to the embodiments of the present disclosure. However, the disclosure is not limited thereto, and other layers of the display panel DP formed by deposition processes may also be formed using the deposition apparatus 1 according to embodiments of the present disclosure.

The second electrode EL2 may be disposed on the emission layers EML1, EML2, EML3 and may face the first electrode EL1. The second electrode EL2 may have an integrated structure extending from the emission areas PA1, PA2, PA3 to the non-emission areas NPA. The second electrode EL2 may be a common electrode.

The encapsulation layer TFE may be disposed on the emission device layer EDL and may be configured to protect the light-emitting diodes ED1, ED2, ED3 of the emission device layer EDL from moisture, oxygen, and/or foreign matter. The encapsulation layer TFE may include a glass substrate or a synthetic resin substrate. However, the disclosure is not limited thereto, and the encapsulation layer TFE may have a laminated structure of an inorganic layer, an organic layer, and an inorganic layer.

A display device according to embodiments of the present disclosure may be applied to various electronic devices. An electronic device according to an embodiment of the present disclosure may include the above-described display device and may further include modules or devices having additional functions beyond the display device.

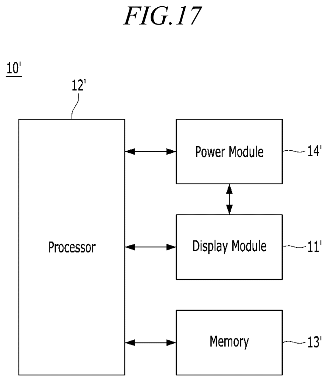

FIG. 17 is a block diagram of an electronic device according to an embodiment of the present disclosure. Referring to FIG. 17, an electronic device 10' according to an embodiment of the present disclosure may include a display module 11', a processor 12', a memory 13', and a power module 14'.

The processor 12' may include at least one selected from a central processing unit (CPU), an application processor (AP), a graphic processing unit (GPU), a communication processor (CP), an image signal processor (ISP), and a controller.

The memory 13' may have stored therein data and information used for operating the processor 12' or the display module 11'. When the processor 12' executes an application stored in the memory 13', image data signals and/or input control signals may be transmitted to the display module 11', which may then process the received signals and output visual information via a display screen.

The power module 14' may include a power supply module, such as a power adapter or battery device, and a power conversion module configured to convert the power supplied by the power supply module into power used for the operation of the electronic device 10'.

At least one of the components of the electronic device 10' described above may be included within the display device according to the embodiments described above. Alternatively, some of the individual modules included in a single functional module may be provided within the display device, while others may be provided separately from the display device. In an embodiment, for example, the display device may include the display module 11', and the processor 12', memory 13', and power module 14' may be provided as separate devices within the electronic device 10' rather than within the display device.

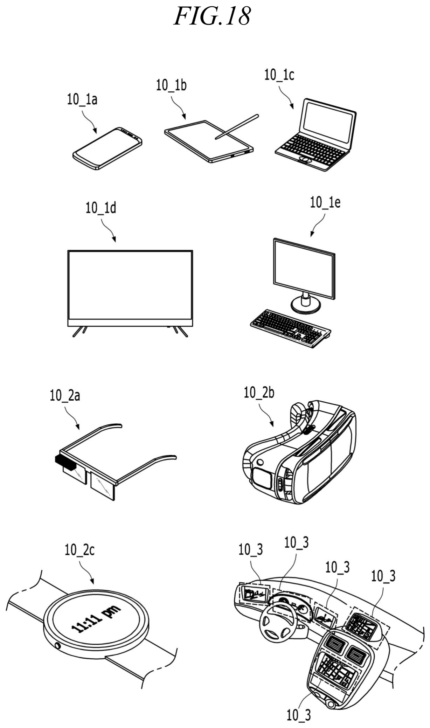

FIG. 18 is a schematic view of electronic devices according to various embodiments of the present disclosure. Referring to FIG. 18, various electronic devices 10' to which the display device according to embodiments of the present disclosure may be applied may include not only image display electronic devices, such as a smartphone 10_1a, a tablet personal computer (PC) 10_1b, a laptop computer 10_1c, a television 10_1d, and a desktop monitor 10_1e, but also wearable electronic devices including a display module, such as smart glasses 10_2a, a head-mounted display 10_2b, and a smartwatch 10_2c, and automotive electronic devices 10_3 including a display module, such as a center information display (CID), a room mirror display, or displays provided in a dashboard, center fascia, or instrument panel of an automobile.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the appended claims.

## Claims

1. A mask assembly (10) comprising:
a mask frame (100) provided with an opening (100a);
a shielding stick (200, 200a) extending across the opening (100a) in a first direction (DR1), wherein both opposing ends of the shielding stick (200, 200a) are coupled to the mask frame (100);
mask sticks (300), each extending across the opening (100a) in a second direction (DR2) intersecting the first direction (DR1), wherein both opposing ends of each of the mask sticks (300) are coupled to the mask frame (100), and each of the mask sticks (300) is provided with pattern holes (301);
a first gap stick (110, 110a) extending across the opening (100a) in the second direction (DR2), wherein both opposing ends of the first gap stick (110, 110a) are coupled to the mask frame (100), and the first gap stick (110, 110a) overlaps, in a plan view, a first gap (G1) defined between the mask sticks (300); and
a thermal expansion control stick (400, 400a, 400b, 400c) extending across the opening (100a) in the second direction (DR2), wherein both opposing ends of the thermal expansion control stick (400, 400a, 400b, 400c) are coupled to the mask frame (100), and the thermal expansion control stick (400, 400a, 400b, 400c) overlaps, in the plan view, the first gap (G1),
wherein the thermal expansion control stick (400, 400a, 400b, 400c) has a coefficient of thermal expansion less than a coefficient of thermal expansion of the first gap stick (110, 110a).

2. The mask assembly (10) of claim 1, wherein the first gap stick (110, 110a) overlaps, in the plan view, a pair of mask sticks (300) adjacent to the first gap (G1) among the mask sticks (300),
wherein the thermal expansion control stick (400, 400a, 400b, 400c) does not overlap, in the plan view, the pair of mask sticks (300),
wherein the first gap stick (110, 110a) has magnetism less than magnetism of the mask sticks (300), and
wherein the thermal expansion control stick (400, 400a, 400b, 400c) has magnetism greater than the magnetism of the first gap stick (110, 110a).

3. The mask assembly (10) of claim 2, wherein the thermal expansion control stick (400, 400a, 400b, 400c) includes a material substantially the same as a material of the mask sticks (300).

4. The mask assembly (10) of any one of claims 1 to 3, wherein the shielding stick (200, 200a) includes a first surface (201, 201a) and a second surface (202), wherein the second surface (202) is opposite to the first surface (201, 201a) and facing the mask frame (100),
wherein the mask sticks (300) and the thermal expansion control stick (400, 400a, 400b, 400c) are disposed on the first surface (201, 201a) of the shielding stick (200, 200a), and
wherein the first gap stick (110, 110a) is disposed on the second surface (202) of the shielding stick (200, 200a).

5. The mask assembly (10) of claim 4, wherein the first gap stick (110, 110a) comprises a first sub-gap stick (111) and a second sub-gap stick (112),
wherein the first sub-gap stick (111) overlaps, in the plan view, one of the mask sticks (300) which is adjacent to the first gap (G1), and the second sub-gap stick (112) overlaps, in the plan view, another one of the mask sticks (300) which is adjacent to the first gap (G1), and
wherein a first sub-gap (SG1) is defined between the first sub-gap stick (111) and the second sub-gap stick (112).

6. The mask assembly (10) of claim 5, wherein the thermal expansion control stick (400, 400a, 400b, 400c) overlaps, in the plan view, the first sub-gap stick (111) and the second sub-gap stick (112).

7. The mask assembly (10) of claim 5 or 6, wherein the thermal expansion control stick (400, 400a, 400b, 400c) covers, in the plan view, the first sub-gap (SG1).

8. The mask assembly (10) of any one of claims 4 to 7, wherein the thermal expansion control stick (400, 400a, 400b, 400c) has a thickness greater than a thickness of the mask sticks (300) in a third direction (DR3) intersecting the first direction (DR1) and the second direction (DR2).

9. The mask assembly (10) of any one of the preceding claims, wherein a second sub-gap (SG2) is defined between one of the mask sticks (300) adjacent to the first gap (G1) and the thermal expansion control stick (400, 400a, 400b, 400c), and
wherein a third sub-gap (SG3) is defined between another one of the mask sticks (300) adjacent to the first gap (G1) and the thermal expansion control stick (400, 400a, 400b, 400c).

10. The mask assembly (10) of claim 9, wherein the second sub-gap (SG2) and the third sub-gap (SG3) have substantially a same width as each other in the first direction (DR1).

11. The mask assembly (10) of claim 9, wherein the second sub-gap (SG2) and the third sub-gap (SG3) have different widths from each other in the first direction (DR1).

12. The mask assembly (10) of any one of claims 9 to 11, wherein the second sub-gap (SG2) and the third sub-gap (SG3) do not overlap, in the plan view, a first sub-gap (SG1) defined in the first gap stick (110, 110a).

13. The mask assembly (10) of any one of claims 1 to 3, wherein the shielding stick (200, 200a) includes a first surface (201, 201a) and a second surface (202), wherein the second surface (202) is opposite to the first surface (201, 201a) and facing the mask frame (100),
wherein the first gap stick (110, 110a) and the thermal expansion control stick (400, 400a, 400b, 400c) are disposed on the second surface (202) of the shielding stick (200, 200a), and
wherein the mask sticks (300) are disposed on the first surface (201, 201a) of the shielding stick (200, 200a).

14. The mask assembly (10) of any one of the preceding claims, further comprising a second gap stick (120) extending across the opening (100a) in the second direction (DR2), wherein both opposing ends of the second gap stick (120) are coupled to the mask frame (100), and the second gap stick (120) covers, in the plan view, a second gap (G2) defined between the mask sticks (300),
wherein the first gap (G1) has a width (W1) greater than a width (W2) of the second gap (G2) in the first direction (DR1).

15. The mask assembly (10) of any one of the preceding claims, wherein the thermal expansion control stick (400, 400a, 400b, 400c) comprises sub-thermal expansion control sticks (401) arranged in parallel in the first direction (DR1),
wherein each of the sub-thermal expansion control sticks (401) extends across the opening (100a) in the second direction (DR2), both opposing ends of each of the sub-thermal expansion control sticks (401) being coupled to the mask frame (100).
